# FASCICULE DE BREVET EUROPEEN

(11) **EP 3 377 672 B1**
(45) Date de publication et mention de la délivrance du brevet: **07.08.2019**
(21) Numéro de dépôt: 16809496.9
(22) Date de dépôt: 15.11.2016
(51) Int. Cl.: C23C 16/12, C23C 16/455, C23C 16/56, C23C 14/58

(54) **PROCEDE DE FORMATION D'OXYDE ET/OU DE NITRURE D'ALUMINIUM**
VERFAHREN ZUR HERSTELLUNG VON ALUMINIUMOXID UND/ODER ALUMINIUMNITRID
METHOD FOR PRODUCING ALUMINUM OXIDE AND/OR ALUMINUM NITRIDE

(30) Priorité: 16.11.2015 FR 1560933
(43) Date de publication de la demande: 26.09.2018
(73) Titulaire: Kobus SAS, 38330 Montbonnot-Saint-Martin (FR)
(72) Inventeur: VITIELLO, Julien, 38190 BERNIN (FR); DELCARRI, Jean-Luc, 38330 Saint Ismier (FR); PIALLAT, Fabien, 38330 Montbonnot (FR)
(74) Mandataire: IP Trust
(86) Numéro de dépôt international: PCT/FR2016/052956
(87) Numéro de publication internationale: WO 2017/085392

(56) Documents cités:
- US-A1- 2006 060 466
- US-A1- 2009 114 942
- US-A1- 2014 124 788

## Description

### DOMAINE DE L'INVENTION

La présente invention concerne un procédé de formation d'oxyde et/ou de nitrure d'aluminium, ainsi qu'un dispositif pour la mise en oeuvre d'un tel procédé.

### ETAT DE LA TECHNIQUE

Pour former une couche d'oxyde ou de nitrure d'aluminium (Al₂O₃ ou AIN), par exemple pour la réalisation de matériaux semi-conducteurs, il est connu de mettre en oeuvre dans une chambre de dépôt un procédé de dépôt par couche atomique (« Atomic Layer Déposition » ou ALD en anglais). Une couche atomique d'aluminium est déposée sur un substrat, dans une chambre de dépôt. Après le dépôt de la couche d'aluminium, la chambre de dépôt est purgée. De l'oxygène ou de l'ammoniaque est ensuite envoyé dans la chambre de dépôt, permettant d'oxyder ou de nitrurer la couche atomique d'aluminium, de manière à former une couche d'oxyde ou de nitrure d'aluminium. La chambre de dépôt est à nouveau purgée avant le dépôt d'une nouvelle couche atomique d'aluminium. Les étapes de dépôt d'aluminium, d'oxydation ou de nitruration, et les purges sont répétées jusqu'à obtention de l'épaisseur souhaitée pour la couche d'oxyde ou de nitrure d'aluminium.

Toutefois, le procédé de dépôt par couche atomique est relativement lent, car il consiste à déposer une seule couche atomique à la fois. Ainsi, pour former une couche d'oxyde ou de nitrure d'aluminium de 50 à 100 nm d'épaisseur, le procédé dure plusieurs heures. En outre, lors de la mise en oeuvre de ce procédé, un dépôt peut se former sur les parois de la chambre de dépôt, mais ce dépôt est difficile à nettoyer. En effet, il est connu de nettoyer les dépôts d'oxyde d'aluminium par trempage dans des bains de gravure, mais cette technique n'est pas adaptée au nettoyage d'une chambre de dépôt.

Pour compenser la faible vitesse de dépôt, il est connu de disposer plusieurs substrats dans la chambre de dépôt afin d'obtenir simultanément une couche d'oxyde d'aluminium sur plusieurs substrats. Toutefois, la présence simultanée de plusieurs substrats entraîne une baisse de l'homogénéité de l'atmosphère de la chambre de dépôt, ce qui pénalise la qualité du dépôt, notamment en ce qui concerne l'homogénéité de l'épaisseur des couches déposées.

C'est à ces inconvénients qu'entend plus particulièrement remédier l'invention en proposant un procédé de formation d'une couche comprenant de l'oxyde et/ou du nitrure d'aluminium, ainsi qu'un dispositif pour la mise en oeuvre d'un tel procédé, permettant de faciliter le nettoyage de la chambre de dépôt lors de la réalisation de couches d'oxyde d'aluminium d'épaisseur importante, c'est-à-dire typiquement comprise entre 20 et 500 nm.

### EXPOSE DE L'INVENTION

A cet effet, l'invention a pour objet un procédé de formation d'une couche comprenant de l'oxyde d'aluminium (Al₂O₃) et/ou du nitrure d'aluminium (AIN) sur un substrat, dans lequel une séquence d'étapes successives a) et b) selon lesquelles :
a) une couche élémentaire d'aluminium présentant une épaisseur comprise entre 5 et 25 nm est déposée sur le substrat dans une chambre de dépôt,
b) le substrat est déplacé dans une chambre de traitement distincte de la chambre de dépôt, dans laquelle la couche élémentaire d'aluminium est oxydée, respectivement nitrurée pour former une couche élémentaire d'oxyde d'aluminium, respectivement de nitrure d'aluminium,
   est répétée en boucle jusqu'à l'obtention de ladite couche d'oxyde et/ou de nitrure d'aluminium par empilement des couches élémentaires successives d'oxyde d'aluminium, respectivement de nitrure d'aluminium.

On notera que, sauf indication contraire, le terme « sur » ne doit pas interprété comme impliquant un contact direct entre deux éléments, mais couvre l'existence éventuelle d'au moins un élément intercalé entre les deux éléments en question.

Selon d'autres caractéristiques avantageuses mais non obligatoires de l'invention, un tel procédé peut incorporer une ou plusieurs des caractéristiques suivantes, prises dans toute combinaison techniquement admissible :
- lors de l'étape b), l'oxydation, respectivement la nitruration, est réalisée par diffusion d'atomes d'oxygène, respectivement d'azote, au travers de la couche élémentaire d'aluminium ;
- un seul substrat à la fois est disposé dans la chambre de dépôt et dans la chambre de traitement ;
- les étapes a) et b) sont répétées jusqu'à ce que l'épaisseur de la couche d'oxyde et/ou de nitrure d'aluminium soit supérieure ou égale à 20 nm, et de préférence inférieure à 500 nm ;
- lors de l'étape a), la couche élémentaire d'aluminium est déposée au moyen d'un procédé de dépôt physique en phase vapeur (PVD) ou de dépôt chimique en phase vapeur (CVD) ;
- le procédé comprend en outre une étape c), dans laquelle :
   - le substrat recouvert de la couche d'oxyde et/ou de nitrure d'aluminium est déplacé dans une chambre intermédiaire distincte de la chambre de dépôt et de la chambre de traitement et étanche vis-à-vis desdites chambres de dépôt et de traitement, puis
   - la chambre de dépôt et/ou la chambre de traitement sont nettoyées.

L'invention peut être mise en oeuvre dans un dispositif qui comprend une chambre de dépôt étanche connectée à une source d'aluminium, une chambre de traitement étanche connectée à une source d'oxygène ou d'azote et une chambre intermédiaire à laquelle sont connectées séparément de manière étanche la chambre de dépôt et la chambre de traitement.

### BREVE DESCRIPTION DES FIGURES

L'invention sera mieux comprise à la lecture de la description qui va suivre, faite en référence aux dessins annexés dans lesquels :
- les figures 1A à 1E illustrent différentes étapes d'un procédé de formation d'oxyde et/ou de nitrure d'aluminium conforme à l'invention ; et
- la figure 2 est un schéma d'un dispositif pour la mise en oeuvre du procédé de formation d'oxyde et/ou de nitrure d'aluminium.

Pour des raisons de lisibilité des figures, les différents éléments illustrés ne sont pas nécessairement représentés à l'échelle.

### DESCRIPTION DETAILLEE DE L'INVENTION

La couche d'oxyde et/ou de nitrure d'aluminium est formée par empilement de couches élémentaires d'oxyde et/ou de nitrure d'aluminium sur un substrat.

La fonction du substrat est de servir de support à la couche d'oxyde et/ou de nitrure d'aluminium qui doit être formée.

Chaque couche élémentaire est formée en deux étapes successives réalisées chacune dans une chambre sous vide spécifique d'un dispositif de dépôt.

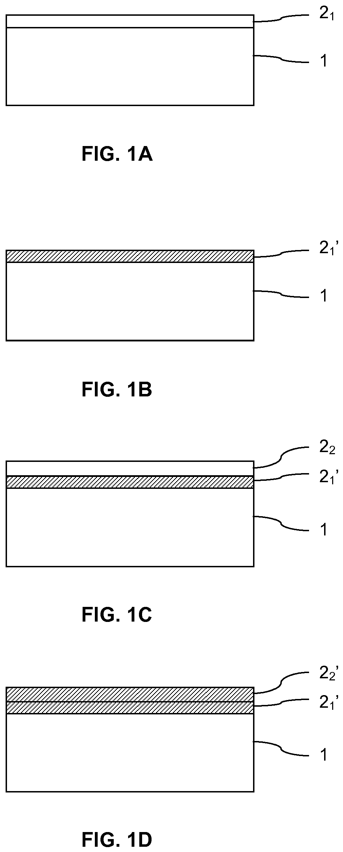

Dans une première étape, illustrée à la figure 1A, une première couche élémentaire 2₁ d'aluminium est déposée sur un substrat 1 dans une première chambre, dite chambre de dépôt. A cet effet, dans le cas d'un dépôt chimique en phase vapeur (CVD), des molécules contenant des atomes d'aluminium sont introduites dans la chambre sous vide et réagissent avec la surface du substrat pour former une couche d'aluminium sur la surface du substrat.

L'épaisseur de cette couche élémentaire est choisie suffisamment fine pour permettre la diffusion ultérieure d'atomes d'oxygène (dans le cas d'une oxydation) ou d'azote (dans le cas d'une nitruration) dans toute l'épaisseur de ladite couche. On considère à cet égard que ladite couche élémentaire d'aluminium doit présenter une épaisseur comprise entre 5 et 25 nm, de préférence entre 5 et 20 nm, voire entre 5 et 15 nm.

Si la couche élémentaire d'aluminium présentait une épaisseur supérieure, une oxydation conduirait à la formation d'une couche superficielle d'oxyde d'aluminium (s'étendant à partir de la surface de la couche élémentaire exposée à l'atmosphère oxydante vers le substrat) qui, à partir d'une épaisseur d'une dizaine de nanomètres, formerait une barrière à l'oxydation de la portion sous-jacente de la couche élémentaire d'aluminium. Dans ces conditions, la portion sous-jacente ne pourrait donc pas être oxydée et l'on obtiendrait une couche composite formée d'une portion superficielle d'oxyde d'aluminium et d'une portion enterrée d'aluminium.

Le dépôt de la couche élémentaire d'aluminium peut être réalisé au moyen d'un procédé de dépôt physique en phase vapeur (PVD, acronyme du terme anglo-saxon « Physical Vapor Déposition ») ou de dépôt chimique en phase vapeur (CVD, acronyme du terme anglo-saxon « Chemical Vapor Déposition »), qui sont beaucoup plus rapides que le procédé de dépôt par couche atomique.

Le dépôt d'une telle couche élémentaire d'aluminium dure une vingtaine de secondes environ.

Le substrat portant la première couche élémentaire d'aluminium est ensuite déplacé dans une seconde chambre, dite chambre de traitement. La chambre de traitement est distincte de la chambre de dépôt et étanche vis-à-vis de celle-ci.

Dans la chambre de traitement, on injecte des espèces contenant de l'oxygène ou de l'azote de sorte à générer une oxydation ou une nitruration de la couche élémentaire d'aluminium 2₁. Au cours de ce traitement, des atomes d'oxygène ou de nitrure diffusent au travers de la première couche élémentaire d'aluminium 2₁, sur toute l'épaisseur de ladite couche. Ainsi, selon l'espèce injectée, on obtient une première couche élémentaire 2₁' d'oxyde d'aluminium ou de nitrure d'aluminium (cf. figure 1B).

L'oxydation ou la nitruration de la couche élémentaire d'aluminium dure une dizaine de secondes environ.

Ensuite, on ramène le substrat 1 recouvert de la première couche élémentaire 2₁' d'oxyde ou de nitrure d'aluminium dans la chambre de dépôt.

De manière particulièrement avantageuse, tous les déplacements du substrats sont réalisés au sein du dispositif sous vide d'air ou dans une atmosphère contrôlée de sorte à éviter toute contamination des couches déposées.

Dans la chambre de dépôt, on procède au dépôt d'une deuxième couche élémentaire 2₂ d'aluminium sur la première couche élémentaire 2₁' d'oxyde ou de nitrure d'aluminium (cf. figure 1C). Les caractéristiques de cette étape de dépôt de la deuxième couche élémentaire d'aluminium sont similaires à celles de l'étape de dépôt de la première couche élémentaire d'aluminium.

On déplace ensuite le substrat recouvert des couches 2₁' et 2₂ dans la chambre de traitement, où l'on met en oeuvre une oxydation ou une nitruration de la deuxième couche élémentaire 2₂ d'aluminium, de sorte à former une deuxième couche élémentaire 2₂' d'oxyde ou de nitrure d'aluminium (cf. figure 1D).

Les caractéristiques de cette étape de traitement de la deuxième couche élémentaire d'aluminium sont similaires à celles de l'étape de traitement de la première couche élémentaire d'aluminium.

Ensuite, on ramène le substrat 1 recouvert des couches élémentaires 2₁' et 2₂' d'oxyde ou de nitrure d'aluminium dans la chambre de dépôt.

Selon l'application visée, il est possible d'effectuer le même traitement (oxydation ou nitruration) dans l'ensemble des étapes de traitement du procédé, ou bien d'appliquer alternativement un traitement d'oxydation et un traitement de nitruration afin d'obtenir un empilement de couches élémentaires d'oxyde d'aluminium et de nitrure d'aluminium. Dans ce dernier cas, on utilise avantageusement un dispositif comprenant deux chambres de traitement, l'une étant reliée à une source d'oxygène et l'autre à une source d'azote, et l'on place le substrat recouvert de la couche élémentaire d'aluminium à traiter dans l'une de ces deux chambres selon le traitement à réaliser.

On répète ainsi une pluralité de fois la séquence de dépôt d'une couche élémentaire d'aluminium et d'oxydation ou de nitruration de ladite couche élémentaire d'aluminium, jusqu'à l'obtention de l'épaisseur souhaitée pour la couche d'oxyde et/ou de nitrure d'aluminium.

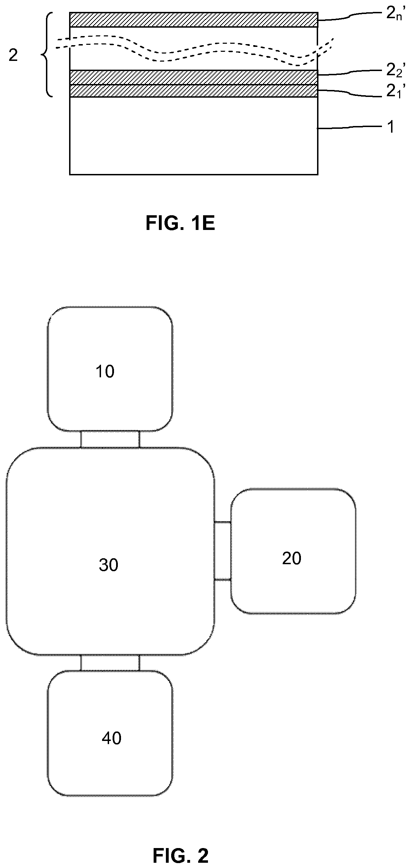

Ainsi, à l'issue de n mises en oeuvre de cette séquence (n étant un entier supérieur ou égal à 2), on obtient, comme illustré sur la figure 1E, un empilement de couches élémentaires 2₁', 2₂', ... 2ₙ' d'oxyde et/ou de nitrure d'aluminium sur le substrat 1, cet empilement formant la couche 2 d'oxyde et/ou de nitrure d'aluminium souhaitée.

De manière particulièrement avantageuse, la couche 2 présente une épaisseur supérieure ou égale à 20 nm, et de préférence inférieure à 500 nm.

Un avantage de ce procédé est qu'en effectuant le dépôt d'aluminium dans une chambre dédiée à cet effet, ne recevant pas d'oxygène ou d'azote, on évite de former un dépôt d'oxyde ou de nitrure d'aluminium difficile à nettoyer sur les parois internes de la chambre de dépôt.

Un autre avantage de ce procédé est que la formation de chaque couche élémentaire d'oxyde ou de nitrure d'aluminium est très rapide (de l'ordre d'une trentaine de secondes), ce qui permet l'obtention de couches épaisses d'oxyde et/ou de nitrure d'aluminium en quelques minutes, ce qui est beaucoup plus rapide que les procédés existants.

Par conséquent, même en mettant à chaque étape du procédé un seul substrat dans la chambre de dépôt ou dans la chambre de traitement - ce qui permet avantageusement de minimiser les inhomogénéités de la couche d'oxyde et/ou de nitrure d'aluminium - le procédé reste économiquement compétitif.

On va maintenant décrire un exemple d'un dispositif permettant la formation d'une couche d'oxyde et/ou de nitrure d'aluminium selon le procédé décrit ci-dessus.

En référence à la figure 2, ledit dispositif comprend une chambre de dépôt 10 étanche et apte à être mise sous vide, connectée à une source d'aluminium (non représentée), ainsi qu'une chambre de traitement 20 étanche connectée à une source d'oxygène ou d'azote (non représentée). Eventuellement, le dispositif comprend deux chambres de traitement, l'une connectée à une source d'oxygène et l'autre à une source d'azote.

Le dispositif comprend en outre un sas d'entrée/sortie 40 par lequel on introduit les substrats sur lesquels on doit former une couche d'oxyde et/ou de nitrure d'aluminium et on retire les substrats sur lesquels ladite couche d'oxyde et/ou de nitrure d'aluminium a été formée.

Ledit sas d'entrée/sortie 40 débouche dans une chambre intermédiaire 30 étanche, laquelle est apte à communiquer séparément avec la chambre de dépôt 10 et avec la ou les chambre(s) de traitement 20. Un système de manipulation et de transport du substrat (non représenté) est agencé à l'intérieur du dispositif pour permettre le déplacement du substrat d'une chambre à une autre.

L'atmosphère dans la chambre 30 est contrôlée, de sorte à éviter toute contamination d'un substrat circulant entre les différentes chambres.

Ainsi, au cours de la formation de la couche d'oxyde et/ou de nitrure d'aluminium, le substrat se déplace entre la chambre intermédiaire 30, la chambre de dépôt 10 et la chambre de traitement 20, lesdites chambres étant fluidiquement isolées les unes des autres pendant la mise en oeuvre des étapes du procédé. Ainsi, on évite toute contamination mutuelle des chambres susceptible de générer des dépôts difficiles à nettoyer sur les parois internes des chambres.

Une fois qu'un substrat ou plusieurs substrats ont été recouverts de la couche d'oxyde et/ou de nitrure d'aluminium, le substrat est retiré du dispositif par la chambre intermédiaire 30 puis par le sas d'entrée/sortie 40 et le nettoyage d'au moins une chambre du dispositif peut être mis en oeuvre.

Dans la mesure où aucun dépôt résultant d'une réaction entre l'aluminium et l'oxygène ou l'azote ne s'est formé sur les parois des chambres, ce nettoyage est aisé à mettre en oeuvre au moyen des techniques à la disposition de l'homme du métier, par exemple par chimie chlorée, de type Cl₂ + BCl₃.

Ainsi, le nettoyage du dispositif est relativement rapide et ne grève pas la productivité du procédé.

## Revendications

1. Procédé de formation d'une couche (2) comprenant de l'oxyde et/ou du nitrure d'aluminium (Al₂O₃ ou AIN) sur un substrat (1), dans lequel une séquence d'étapes successives a) et b) selon lesquelles :
a) une couche élémentaire d'aluminium (2₁, 2₂) présentant une épaisseur comprise entre 5 et 25 nm est déposée sur le substrat (1) dans une chambre de dépôt (10),
b) le substrat (1) est déplacé dans une chambre de traitement (20) distincte de la chambre de dépôt (10), dans laquelle la couche élémentaire d'aluminium (2₁, 2₂) est oxydée, respectivement nitrurée pour former une couche élémentaire d'oxyde d'aluminium, respectivement de nitrure d'aluminium (2₁', 2₂'),
est répétée en boucle jusqu'à l'obtention de ladite couche d'oxyde et/ou de nitrure d'aluminium (2) par empilement des couches élémentaires successives (2₁', 2₂') d'oxyde d'aluminium, respectivement de nitrure d'aluminium.

2. Procédé selon la revendication 1, **caractérisé en ce que** lors de l'étape b), l'oxydation, respectivement la nitruration, est réalisée par diffusion d'atomes d'oxygène, respectivement d'azote, au travers de la couche élémentaire d'aluminium (2₁, 2₂).

3. Procédé selon l'une des revendications 1 ou 2, **caractérisé en ce qu'**un seul substrat (1) à la fois est disposé dans la chambre de dépôt (10) et dans la chambre de traitement (20).

4. Procédé selon l'une des revendications 1 à 3, **caractérisé en ce que** les étapes a) et b) sont répétées jusqu'à ce que l'épaisseur de la couche d'oxyde et/ou de nitrure d'aluminium (2) soit supérieure ou égale à 20 nm, et de préférence inférieure à 500 nm.

5. Procédé selon l'une des revendications 1 à 4, **caractérisé en ce que** lors de l'étape a), la couche élémentaire d'aluminium (2₁, 2₂) est déposée au moyen d'un procédé de dépôt physique en phase vapeur (PVD) ou de dépôt chimique en phase vapeur (CVD).

6. Procédé selon l'une des revendications 1 à 5, **caractérisé en ce qu'**il comprend en outre une étape c), dans laquelle :
- le substrat (1) recouvert de la couche (2) d'oxyde et/ou de nitrure d'aluminium est déplacé dans une chambre intermédiaire (30) distincte de la chambre de dépôt (10) et de la chambre de traitement (20) et étanche vis-à-vis desdites chambres de dépôt et de traitement, puis
- la chambre de dépôt (10) et/ou la chambre de traitement (20) sont nettoyées.

## Patentansprüche

1. Verfahren zur Bildung einer Schicht (2), welche Aluminiumoxid und/oder Aluminiumnitrid (Al₂O₃ oder AIN) auf einem Substrat (1) umfasst, in dem eine Abfolge der Schritte a) und b), in denen:
a) eine Aluminium-Elementarschicht (2₁, 2₂) mit einer Dicke zwischen 15 und 25 nm auf dem Substrat (1) in einer Abscheidungskammer (10) aufgetragen wird,
b) das Substrat (1) in eine Behandlungskammer (20) gelegt wird, die nicht die Abscheidungskammer (10) ist, und in welcher die Aluminium-Elementarschicht (2₁, 2₂) oxidiert bzw. nitriert wird, um eine Aluminiumoxid-Elementarschicht bzw. eine Aluminiumnitrid-Elementarschicht (2₁,2₂) zu bilden,
in einer Schleife so oft wiederholt wird, bis besagte Aluminiumoxid- und/oder Aluminiumnitritschicht (2) durch Übereinanderlagerung der aufeinanderfolgenden Elementarenschichten (2₁,2₂) aus Aluminiumoxid bzw. Aluminiumnitrid erzielt wird.

2. Verfahren nach Anspruch 1, **dadurch gekennzeichnet, dass** in Schritt b) die Oxidation bzw. das Nitrieren durch die Diffusion von Sauerstoff- bzw. Stickstoffatomen durch die Aluminium-Elementarschicht (2₁, 2₂) hindurch erfolgt.

3. Verfahren nach einem der Ansprüche 1 oder 2, **dadurch gekennzeichnet, dass** immer nur ein einziges Substrat (1) in die Abscheidungskammer (10) und in die Behandlungskammer (20) gelegt wird.

4. Verfahren nach einem der Ansprüche 1 bis 3, **dadurch gekennzeichnet, dass** die Schritte a) und b) so oft wiederholt werden, bis die Dicke der Aluminiumoxid- und/oder Aluminiumnitritschicht (2) größer/gleich 20 nm, und vorzugsweise kleiner 500 nm ist.

5. Verfahren nach einem der Ansprüche 1 bis 4, **dadurch gekennzeichnet, dass** in Schritt a) die elementare Aluminiumschicht (2₁, 2₂) mit einem physikalischen Verfahren der Dampfabscheidung (PVD) oder einem chemischen Verfahren der Dampfabscheidung (CVD) aufgetragen wird.

6. Verfahren nach einem der Ansprüche 1 bis 5, **dadurch gekennzeichnet, dass** es des Weiteren einen Schritt umfasst, in dem:
- das Substrat (1), welches mit der Aluminiumoxid- und/oder Aluminiumnitridschicht bedeckt ist, in eine Zwischenkammer (30) verlagert wird, die nicht die Abscheidungskammer (10) und nicht die Behandlungskammer (20) ist und die gegenüber der Abscheidungs- und der Behandlungskammer abgedichtet ist, und in dem
- die Abscheidungskammer (10) und/oder die Behandlungskammer (20) gereinigt werden.

## Claims

1. A method for producing a layer (2) containing aluminum oxide and/or aluminum nitride (Al₂O₃, or AlN) on a substrate (1), said method comprising a sequence of consecutive steps a) and b) according to which:
a) an elemental layer of aluminum (2₁, 2₂) having a thickness between 5 and 25nm is deposited onto the substrate (1) in a deposition chamber (10),
b) the substrate (1) is moved into a treatment chamber (20) separate from the deposition chamber (10), wherein the elemental layer of aluminum (2₁, 2₂) is oxidized, respectively nitrided to produce an elemental layer of aluminum oxide, respectively aluminum nitride (2₁', 2₂'),
is repeated in a loop until said layer of aluminum oxide and/or aluminum nitride (2) is obtained by stacking the successive elemental layers (2₁', 2₂') of aluminum oxide, respectively aluminum nitride.

2. A method according to claim 1, **characterized in that**, in step b), oxidation, respectively nitriding, is achieved by diffusing atoms of oxygen, respectively of nitrogen, through the elemental layer of aluminum (2₁, 2₂).

3. A method according to one of claims 1 or 2, **characterized in that** a single substrate (1) at a time is arranged in the deposition chamber (10) and in the treatment chamber (20).

4. A method according to one of claims 1 to 3, **characterized in that** the steps a) and b) are repeated until the thickness of the oxide and/or aluminum nitride layer (2) is greater than or equal to 20nm, and preferably less than 500nm.

5. A method according to one of claims 1 to 4, **characterized in that** in step a), the elemental aluminum layer (2₁, 2₂) is deposited using a physical vapor deposition (PVD) or chemical vapor deposition (CVD) method.

6. A method according to one of claims 1 to 5, **characterized in that** it further comprises a step c), wherein:
- the substrate (1) covered with the aluminum oxide and/or aluminum nitride layer (2) is moved into an intermediate chamber (30) separate from the deposition chamber (10) and the treatment chamber (20) and sealed relative to said deposition and treatment chambers, then
- the deposition chamber (10) and/or the treatment chamber (20) are cleaned.
